# EUROPEAN PATENT APPLICATION

(11) **EP 4 718 712 A1**
(43) Date of publication of application: **01.04.2026**
(21) Application number: 24214103.4
(22) Date of filing: 20.11.2024
(51) Int. Cl.: H02S 20/26, H02S 30/10, H02S 40/34, H10F 19/80

(54) **PEROVSKITE SOLAR ENERGY GENERATION MODULE AND CONSTRUCTION-SHADING DEVICE**

(30) Priority: 30.09.2024 TW 113137459
(71) Applicant: Golden Artistan Technology Industrial Co., Ltd., Taichung City 408 (TW)
(72) Inventor: WU, LU-CHIEN, 507 Xianxi Township, Changhua County (TW)
(74) Representative: Cabinet Chaillot

(57) **Abstract**

A perovskite solar energy generation module (100,100A,100B,100C) includes a solar panel frame (10), at least one solar panel (20,20A,20B,20C), a first protective panel (30), a second protective panel (40), and a sealing structure (50). The solar panel (20,20A,20B,20C) is disposed on the solar panel frame (10). The solar panel frame (10) is engaged between the first protective panel (30) and the second protective panel (40) and is surrounded by the sealing structure (50). A sealed cavity (51) formed between the first protective panel (30), the second protective panel (40), and the sealing structure (50), preventing the solar panel (20,20A,20B,20C) from being easily oxidized due to environment and hence improving the stability. A construction-shading device (200,200A,200B,200C) is further provided, wherein the perovskite solar energy generation module (100,100A,100B,100C) is disposed in an outer frame (70,70A,70B,70C). The construction-shading device (200,200A,200B,200C) could have different designs to meet different architectural styles and requirements.

## Description

### BACKGROUND OF THE INVENTION

### Technical Field

The present invention relates generally to a solar energy generation module, and more particularly to a perovskite solar energy generation module and a construction-shading device having the same.

### Description of Related Art

With the development of the renewable energy technology, solar energy generation systems have become an important energy solution. A conventional solar energy generation system mainly relies on a plurality of solar panels that are independent, wherein the solar panels are typically installed on a roof or other open areas to capture sunlight and to convert sunlight to electrical energy. However, such design has limitations, including occupation of space, high installation cost, and influence on the appearance of the construction.

With the advance of the technology, solar windows are provided, wherein the solar windows provide natural lighting and visual transparency and effectively convert sunlight into electrical energy. Typically, the solar windows are made of transparent or translucent material and are provided with solar cells, such as perovskite solar cells, inside the solar windows. Such design could partially achieve energy self-sufficiency without affecting the appearance of the construction.

Although the solar windows have advantages, the solar windows still have problems. The design of the solar windows usually lacks flexibility, limiting the use of the solar windows in different constructions and leads to inefficient use of solar energy. Moreover, the perovskite solar cells in practice are easily affected by environmental factors that oxidize the perovskite solar cells, thereby reducing the service life of the solar windows.

Therefore, how to improve the stability of the perovskite solar cells in practice, enhance the use and functionality of the solar panels on the construction, and provide a variety of designs to promote the development of green building, have become a major issue in the industry.

### BRIEF SUMMARY OF THE INVENTION

In view of the above, the primary objective of the present invention is to provide a perovskite solar energy generation module and a construction-shading device, so that the stability of the perovskite solar energy generation module used in the construction-shading device could be improved and the construction-shading device could have a diverse variety of designs, thereby bringing the renewable energy to the daily life and promoting the development of green building.

The present invention provides a perovskite solar energy generation module including a solar panel frame, at least one solar panel, a first protective panel, a second protective panel, and a sealing structure. The solar panel frame is a frame and includes at least one opening. The solar panel frame has two first holes. The at least one opening communicates with the two first holes. The at least one solar panel is a perovskite solar panel and is disposed on the at least one opening. The at least one solar panel is electrically connected to a positive electrode lead and a negative electrode lead. The positive electrode lead and the negative electrode lead pass through the two first holes, respectively. The first protective panel and the second protective panel abut against two sides of the solar panel frame, respectively. The positive electrode lead and the negative electrode lead pass between the first protective panel and the second protective panel and then extend outward. The sealing structure surrounds the solar panel frame and is engaged with a periphery of the first protective panel and a periphery of the second protective panel. The sealing structure encloses a part of the positive electrode lead and a part of the negative electrode lead that extend out of the first protective panel and the second protective panel. A sealed cavity is formed between the first protective panel, the second protective panel, and the sealing structure.

The present invention further provides a construction-shading device including an outer frame and the perovskite solar energy generation module. The outer frame includes two lateral frames, a top frame connected between two top ends of the two lateral frames, and a bottom frame connected between two bottom ends of the two lateral frames. A solar module slot is formed on an inside of the outer frame. A second threaded portion is provided in the outer frame. Two second holes communicate between the solar module slot and the second threaded portion. A periphery of the perovskite solar energy generation module is fixed in the solar module slot by using a filling material. The positive electrode lead and the negative electrode lead of the perovskite solar energy generation module pass through the two second holes to enter the second threaded portion.

With the aforementioned design, the first protective panel, the second protective panel, and the sealing structure of the perovskite solar energy generation module enclose the solar panel frame to form the sealed cavity, so that the perovskite solar cell could be prevented from being oxidized, thereby improving the stability of the perovskite solar energy generation module in practice could be improved and enhancing the service life of the perovskite solar energy generation module. In this way, the perovskite solar energy generation module has a good market application potential.

Moreover, the construction-shading device could be the push door, the push window, the fixed window, the glass railing, the skylight, or other configurations, wherein the outer frame is for accumulate the perovskite solar energy generation module. In this way, the construction-shading device could enhance the use of the solar panels in the construction and bring the renewable energy to the daily life, thereby improving the energy self-sustainability of the construction. Additionally, the diverse variety of designs of the construction-shading device allows architects and designers to flexibly create and design based on different architectural styles and functionalities.

### BRIEF DESCRIPTION OF THE SEVERAL VIEWS OF THE DRAWINGS

The present invention will be best understood by referring to the following detailed description of some illustrative embodiments in conjunction with the accompanying drawings, in which
FIG. 1 is a perspective view of the perovskite solar energy generation module according to a first embodiment of the present invention;
FIG. 2 is an exploded view of the perovskite solar energy generation module according to the first embodiment of present invention;
FIG. 3 is a partially enlarged view of a marked region A in FIG. 2;

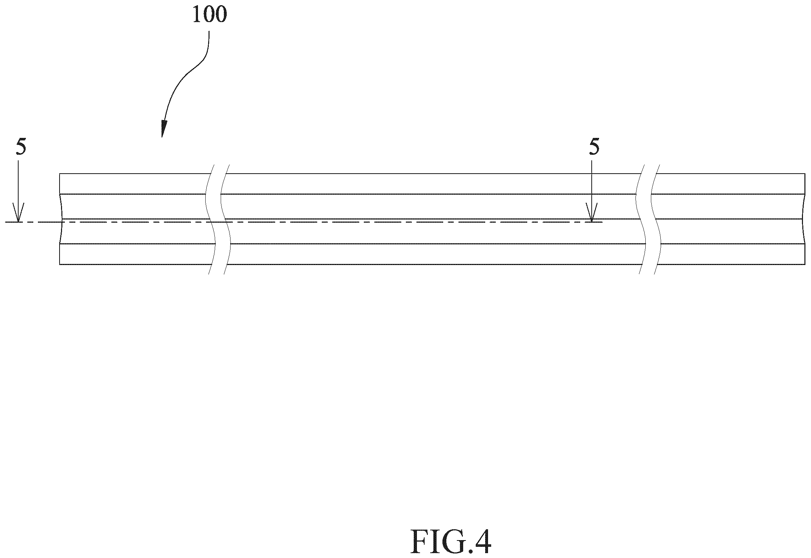

FIG. 4 is a bottom view of the perovskite solar energy generation module according to the first embodiment of present invention;
FIG. 5 is a sectional view along the 5-5 line in FIG. 4;
FIG. 6 is a partially enlarged view of a marked region B in FIG. 5;

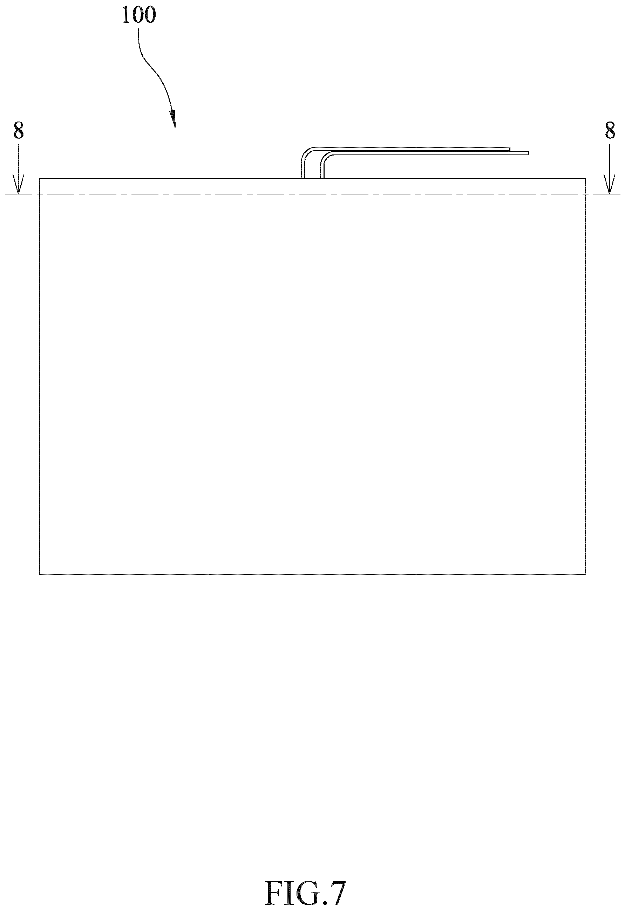

FIG. 7 is a front view of the perovskite solar energy generation module according to the first embodiment of present invention;
FIG. 8 is a sectional view along the 8-8 line in FIG. 7;
FIG. 8A is a partially enlarged view of a marked region 8A in FIG. 8;
FIG. 9 is a front view of the construction-shading device according to a second embodiment of the present invention;
FIG. 10 is a sectional view along the 10-10 line in FIG. 9;
FIG. 11 is a sectional view along the 11-11 line in FIG. 9;
FIG. 12 is a front view of the construction-shading device according to a third embodiment of the present invention;
FIG. 13 a front view of the construction-shading device according to a fourth embodiment of the present invention; and
FIG. 14 is a front view of the construction-shading device according to a fifth embodiment of the present invention.

### DETAILED DESCRIPTION OF THE INVENTION

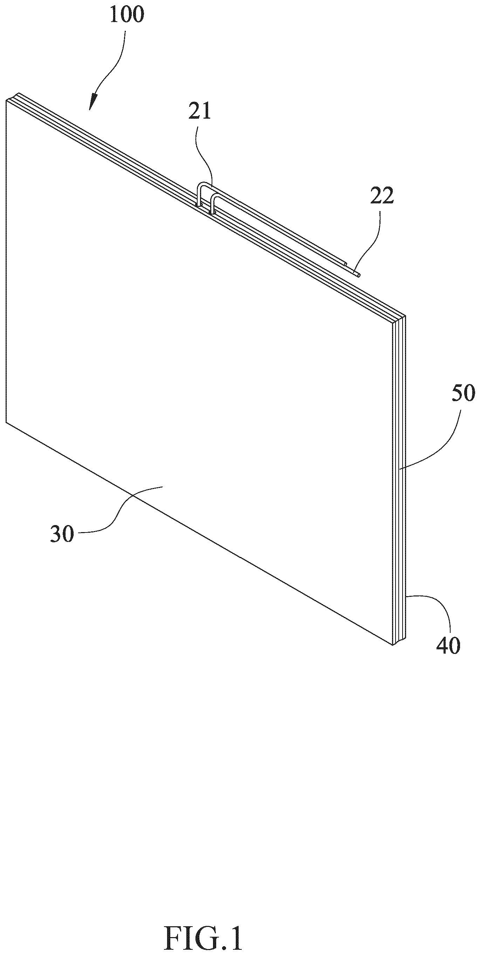

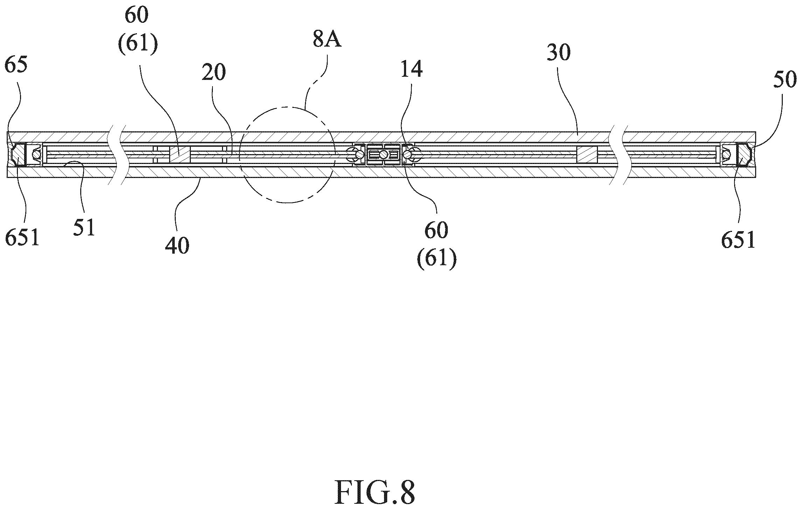

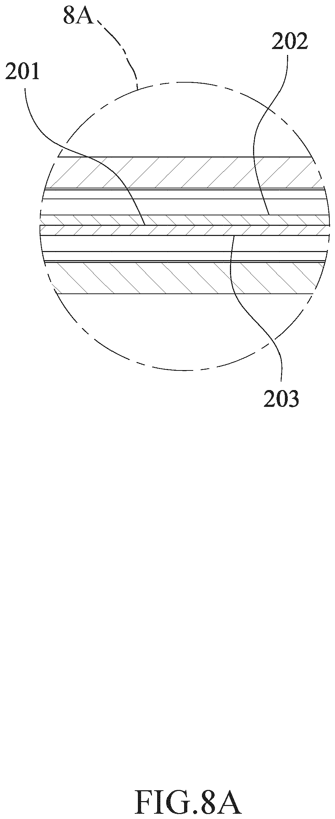

A perovskite solar energy generation module 100 according to a first embodiment of the present invention is illustrated in FIG. 1 and FIG. 8 and includes a solar panel frame 10, four solar panels 20, a first protective panel 30, a second protective panel 40, and a sealing structure 50.

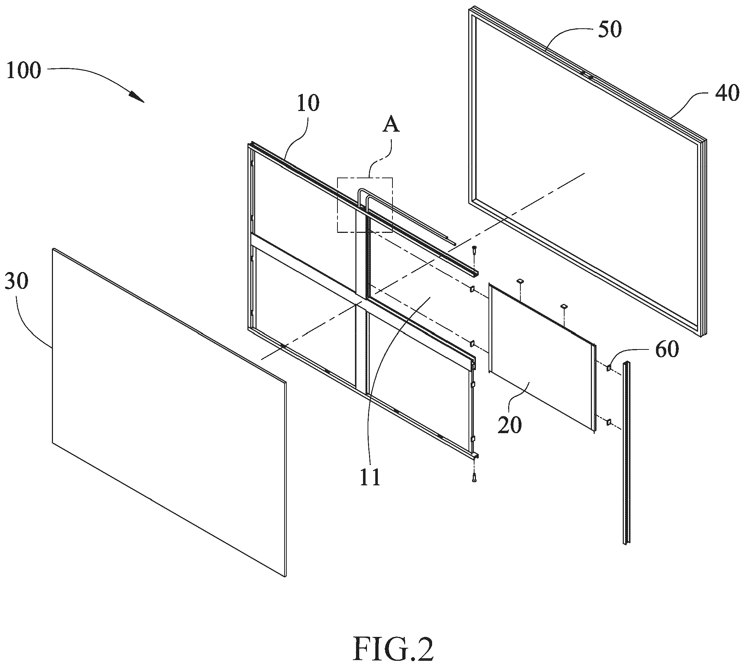

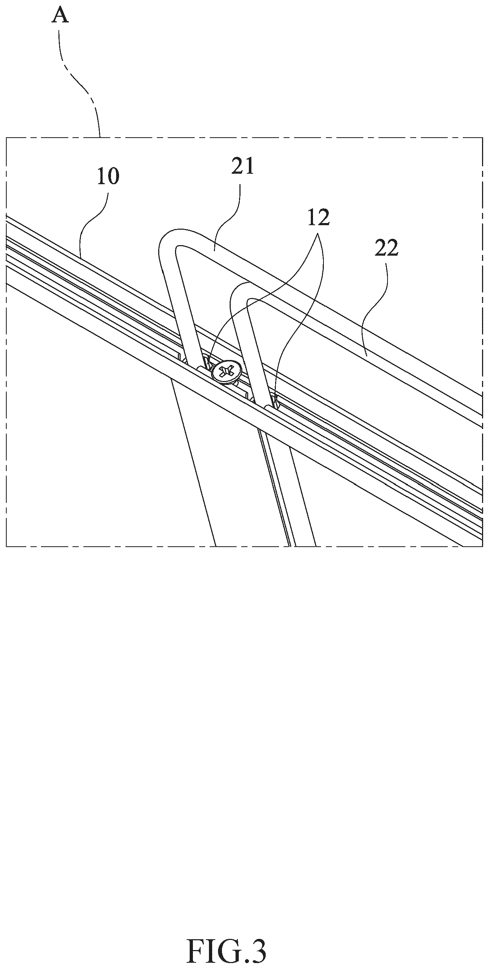

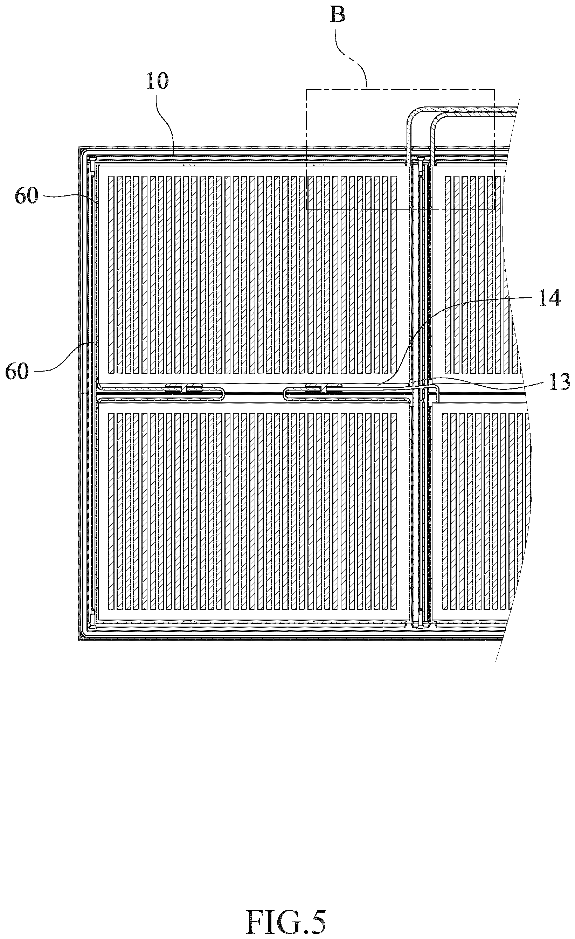

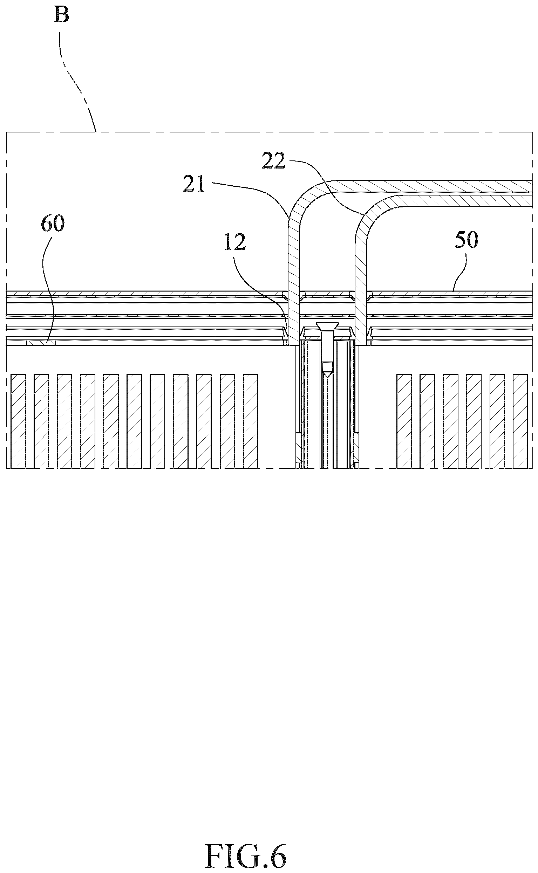

Referring to FIG. 2, FIG. 3, and FIG. 5, the solar panel frame 10 is an extruded aluminum structure that is rectangular. The solar panel frame 10 has four openings 11 that form a 2x2 matrix arrangement. The solar panel frame 10 further has two first holes 12. Each of the openings 11 is a rectangular hole. The two first holes 12 are formed on a side of the solar panel frame 10. Referring to FIG. 5, FIG. 6, and FIG. 8, a plurality of solar panel slots 14 is formed on a periphery of the solar panel frame 10 corresponding to the openings 11. A first threaded portion 13 is formed in the solar panel frame 10. The first threaded portion 13 communicates with the two first holes 12. Each of the solar panel slots 14 on a periphery of each of the openings 11 communicates with the two first holes 12 through the first threaded portion 13, so that each of the openings 11 and each of the solar panel slots 14 communicate with the two first holes 12.

Each of the solar panels 20 is a rectangular plate. A part of periphery of each of the solar panels 20 is fitted into each of the solar panel slots 14 through an insulator 60, so that each of the solar panels 20 covers each of the openings 11. More specifically, the insulator 60 includes a plurality of gaskets 61. The gaskets 61 are arranged by intervals and abut between the part of the periphery of each of the solar panels 20 and an inner wall of each of the solar panel slots 14, so that the fixing effect of the periphery of each of the solar panels 20 being fitted into each of the solar panel slots 14 could be enhanced and each of the solar panels 20 could be prevented from direct contact with the solar panel frame 10, thereby preventing short circuit. In other embodiments, the solar panel frame 10 is not limited to the extruded aluminum structure; the insulator 60 could be changed from the plurality of gaskets 61 to a single washer or a plurality of plastic bars.

Referring to FIG. 2, FIG. 3, and FIG. 8A, each of the solar panels 20 is a perovskite solar panel. Each of the solar panels 20 is a structure formed by laminating a perovskite solar cell 201 between a top encapsulation 202 and a bottom encapsulation 203. The solar panels 20 are connected in series by leads passing through the first threaded portion 13, so that the solar panels 20 are electrically connected in series. A positive electrode lead 21 and a negative electrode lead 22 are provided and pass through the two first holes 12, respectively. In the current embodiment, the perovskite solar cell 201 of each of the solar panels 20 is a bifacial cell, thereby enhancing the efficiency in absorbing solar energy. In other embodiments, each of the solar panels 20 is not limited to the bifacial cell and could make use of other types of perovskite solar cells; the way to electrically connect the solar panels 20 to one another is not a limitation of the present invention.

Referring to FIG. 1, FIG. 2, and FIG. 8, both the first protective panel 30 and the second protective panel 40 are made of glass. More specifically, both the first protective panel 30 and the second protective panel 40 are a glass plate with an area slightly greater than an area of the solar panel frame 10. The first protective panel 30 and the second protective panel 40 abut against two sides of the solar panel frame 10, respectively. The positive electrode lead 21 and the negative electrode lead 22 pass between the first protective panel 30 and the second protective panel 40 and then extend outward. Both the first protective panel 30 and the second protective panel 40 are a rectangular glass plate. Four aluminum bars 65 are respectively provided on either four sides of the first protective panel 30 or four sides of the second protective panel 40. Each of the four aluminum bars 65 is an elongated hollow body. The four aluminum bars 65 surround four sides of the solar panel frame 10. One of the aluminum bars 65 has through holes for the positive electrode lead 21 and the negative electrode lead 22 to pass through. The aluminum bars 65 are filled with a desiccant 651. A plastic material is filled between a periphery of the first protective panel 30 and a periphery of the second protective panel 40 and is in contact with an outside of each of the aluminum bars 65. Then, the plastic material is solidified to form the sealing structure 50. The sealing structure 50 is engaged with the periphery of the first protective panel 30 and the periphery of the second protective panel 40 and surrounds the solar panel frame 10. The sealing structure 50 is in contact with the outside of each of the aluminum bars 65. Moreover, the sealing structure 50 also encloses a part of the positive electrode lead 21 and a part of the negative electrode lead 22 that extend out of the first protective panel 30 and the second protective panel 40. A sealed cavity 51 is formed between the first protective panel 30, the second protective panel 40, and the sealing structure 50. The sealed cavity 51 isolates the solar panels 20 in the sealed cavity 51 from an external environment, thereby preventing the perovskite solar cell 201 of each of the solar panels 20 from being oxidized. The desiccant 651 is adapted to further absorb moisture in the sealed cavity 51, so that the problem of the perovskite solar cell 201 of each of the solar panels 20 being easily oxidized could be relieved, thereby improving the stability and the service life of the solar panels 20. In other embodiments, the first protective panel 30 and the second protective panel 40 are not limited to being made of glass, but could be other plates that allow light to pass through; the aluminum bars 65 on the four sides of the solar panel frame 10 could be omitted and the sealing structure 50 is directly disposed around the solar panel frame 10 and engaged between the periphery of the first protective panel 30 and the periphery of the second protective panel 40.

The solar panel frame 10 of the perovskite solar energy generation module100 is provided with the first threaded portion 13 communicating with the openings 11 and the two first holes 12, thereby facilitating the installation and connection of the leads connecting the solar panels 20 in series. Moreover, the first protective panel 30, the second protective panel 40, and the sealing structure 50 of the perovskite solar energy generation module100 encloses the solar panel frame 10 to form the sealed cavity 51, so that the risk of oxidizing the perovskite solar cell 201 of each of the solar panels 20 could be reduced, thereby improving the stability of the perovskite solar energy generation module 100 in practice and enhancing the service life of the perovskite solar energy generation module 100. In this way, the perovskite solar energy generation module 100 has a good market application potential.

In the first embodiment, the solar panel frame 10 has four openings 11, and four solar panels 20 are provided on the openings 11. In other embodiments, the solar panel frame 10 could be provided with only one opening 11, and one solar panel 20 is provided on the opening 11; alternatively, the solar panel frame 10 could be provided with a plurality of openings 11, and a plurality of solar panels 20 are respectively provided on the openings 11, wherein both the openings 11 and the solar panels 20 form a matrix arrangement on the solar panel frame 10.

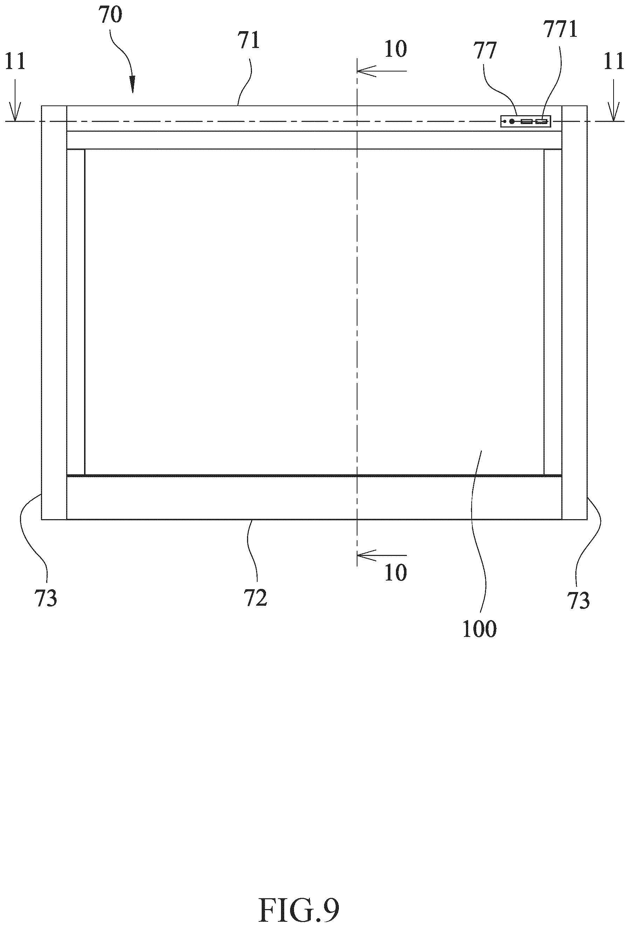

A construction-shading device 200 according to a second embodiment of the present invention is illustrated in FIG. 9. In the second embodiment, the construction-shading device 200 is a fixed window. The construction-shading device 200 includes an outer frame 70 and the perovskite solar energy generation module 100 of the first embodiment.

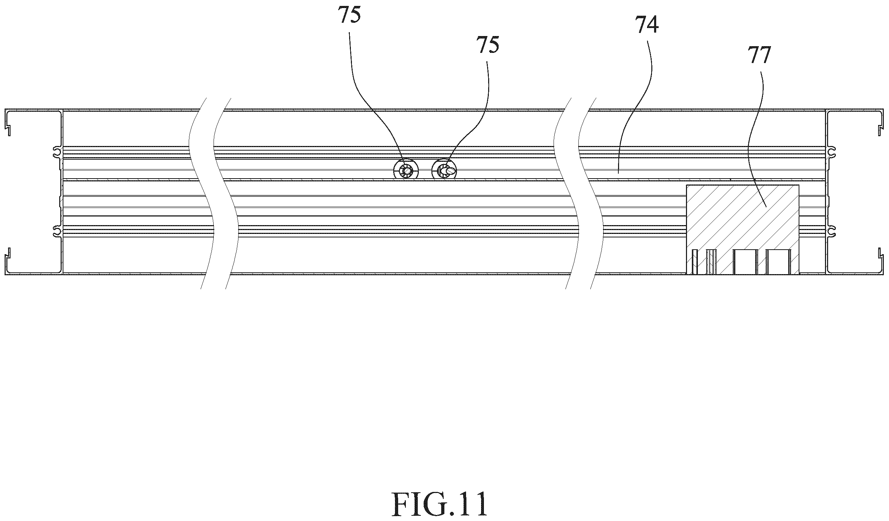

Referring to FIG. 9, FIG. 10, and FIG. 11, the outer frame 70 is an extruded aluminum frame that is hollow and rectangular. A second threaded portion 74 is formed in the outer frame 70. The outer frame 70 includes two lateral frames 73, a top frame 71 connected between two top ends of the two lateral frames 73, and a bottom frame 72 connected between two bottom ends of the two lateral frames 73. A solar module slot 76 is formed on an inside of the outer frame 70. Two second holes 75 penetrate through a side of an inner wall of the solar module slot 76. The solar module slot 76 communicates with the second threaded portion 74 through the two second holes 75. A junction box 77 is fixed in the outer frame 70. The junction box 77 has a plurality of jacks 771. The jacks 771 are exposed on a surface of the outer frame 70.

A periphery of the perovskite solar energy generation module 100 is fixed in the solar module slot 76 by using a filling material 80. The positive electrode lead 21 and the negative electrode lead 22 of the perovskite solar energy generation module 100 pass through the two second holes 75 to enter the second threaded portion 74 and to connect to the junction box 77, so that an electrical energy generated by the perovskite solar energy generation module 100 could be supplied to the junction box 77. In this way, external electronic appliances or electronic devices could use the electrical energy generated by the perovskite solar energy generation module 100 through wires connecting to the jacks 771.

In other embodiments, the junction box 77 in the outer frame 70 could be omitted, and the positive electrode lead 21 and the negative electrode lead 22 of the perovskite solar energy generation module 100 passing through the second threaded portion 74 extend out of the outer frame 70 to connect to a rechargeable cell or a junction box outside the outer frame 70 for directly supplying electricity. In the second embodiment, the junction box 77 in the outer frame 70 could be selectively omitted based on the requirement.

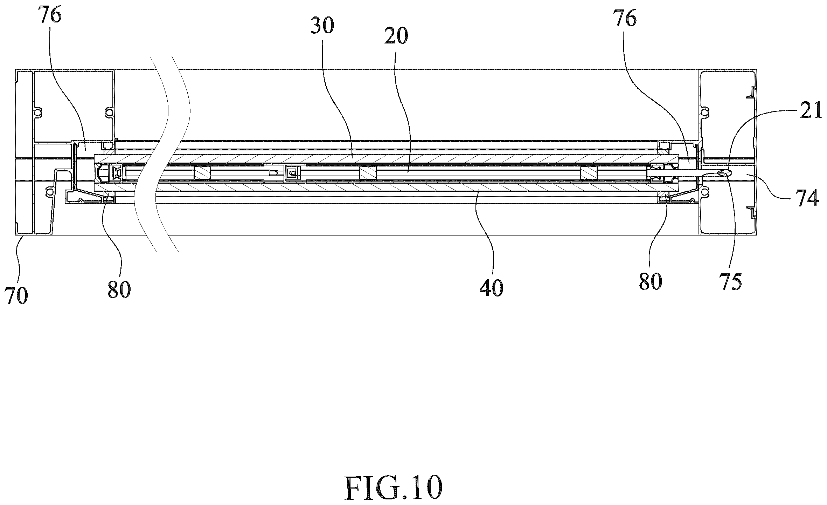

Referring to FIG. 10, in the second embodiment, the periphery of the perovskite solar energy generation module 100 is fixed in the solar module slot 76 by using the filling material 80. In other embodiments, the perovskite solar energy generation module 100 could be fixed in the solar module slot 76 of the outer frame 70 by using gaskets, washers, or plastic bars.

The perovskite solar energy generation module 100 of the second embodiment has a structure identical to the perovskite solar energy generation module 100 of the first embodiment and includes four solar panels 20, wherein the solar panels 20 are electrically connected in series. Similarly, in the second embodiment, the perovskite solar energy generation module 100 could include one solar panel 20 or a plurality of solar panels 20; the solar panels 20 could be electrically connected in series or in parallel.

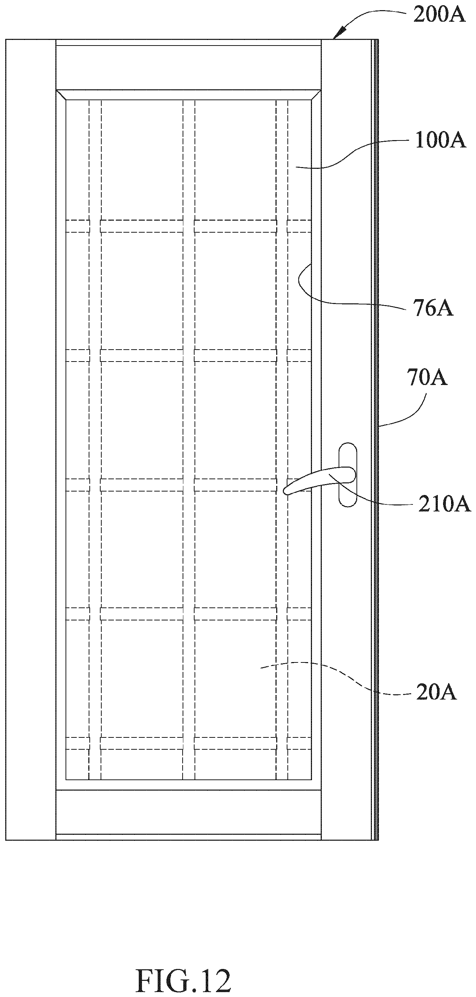

A construction-shading device 200A according to a third embodiment of the present invention is illustrated in FIG. 12 and is a push door. The construction-shading device 200A includes an outer frame 70A and a perovskite solar energy generation module 100A. A solar module slot 76A is formed on an inside of the outer frame 70A. The perovskite solar energy generation module 100A includes ten solar panels 20A that are electrically connected. The perovskite solar energy generation module 100A of the third embodiment is similar to the perovskite solar energy generation module 100 of the second embodiment, as a periphery of the perovskite solar energy generation module 100A of the third embodiment is fixed in the solar module slot 76A by using the filling material 80. Moreover, a handle 210A is disposed on the outer frame 70A and is adapted to manually open and close the construction-shading device 200A.

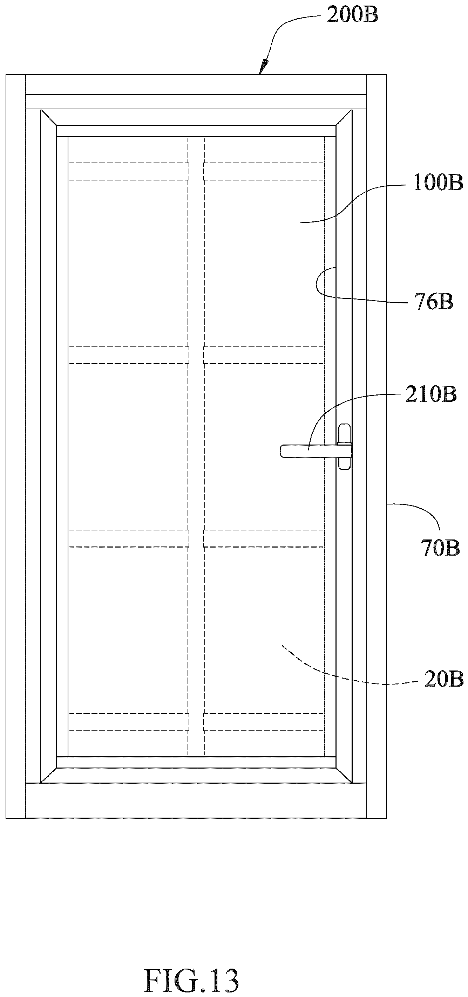

A construction-shading device 200B according to a fourth embodiment of the present invention is illustrated in FIG. 13 and is a push window. The construction-shading device 200B includes an outer frame 70B and a perovskite solar energy generation module 100B. A solar module slot 76B is formed on an inside of the outer frame 70B. The perovskite solar energy generation module 100B includes six solar panels 20B that are electrically connected. The perovskite solar energy generation module 100B of the fourth embodiment is similar to the perovskite solar energy generation module 100 of the second embodiment, as a periphery of the perovskite solar energy generation module 100B is fixed in the solar module slot 76B by using the filling material 80. Moreover, a handle 210B is disposed on the outer frame 70B and is adapted to manually open and close the construction-shading device 200B.

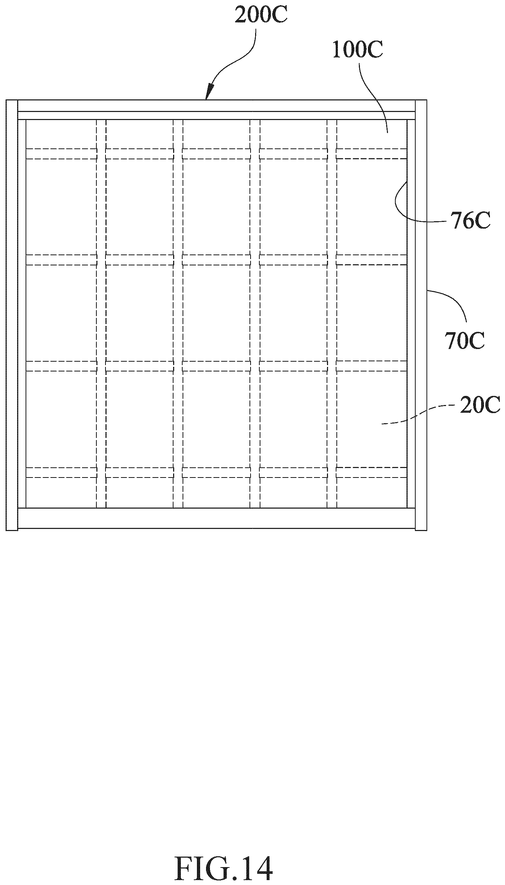

A construction-shading device 200C according to a fifth embodiment of the present invention is illustrated in FIG. 14 and is a fixed window. The construction-shading device 200C includes an outer frame 70C and a perovskite solar energy generation module 100C. A solar module slot 76C is formed on an inside of the outer frame 70C. The perovskite solar energy generation module 100C includes six solar panels 20C that are electrically connected. The perovskite solar energy generation module 100C of the fifth embodiment is similar to the perovskite solar energy generation module 100 of the second embodiment, as a periphery of the perovskite solar energy generation module 100C is fixed in the solar module slot 76C by using the filling material 80.

From the second embodiment to the fifth embodiment, the construction-shading device 200, 200A, 200B, 200C is provided with the outer frame 70, 70A, 70B, 70C for corresponding accumulating the perovskite solar energy generation module 100, 100A, 100B, 100C. In this way, the construction-shading device 200, 200A, 200B, 200C could enhance the use of the solar panels in the construction and bring the renewable energy to the daily life, thereby improving the energy self-sustainability of the construction. Moreover, the diverse variety of designs of the construction-shading device allows architects and designers to flexibly create and design based on different architectural styles and functionalities. Apart from the push door, the push window, and the fixed window, the construction-shading device could also be a glass railing, a skylight, or other configurations.

## Claims

1. A perovskite solar energy generation module (100,100A,100B,100C), comprising:
a solar panel frame (10) which is a frame, wherein the solar panel frame (10) includes at least one opening (11) and has two first holes (12); the at least one opening (11) communicates with the two first holes (12);
at least one solar panel (20,20A,20B,20C) which is a perovskite solar panel, wherein the at least one solar panel (20,20A,20B,20C) is disposed on the at least one opening (11); the at least one solar panel (20,20A,20B,20C) is electrically connected to a positive electrode lead (21) and a negative electrode lead (22); the positive electrode lead (21) and the negative electrode lead (22) pass through the two first holes (12), respectively;
a first protective panel (30), a second protective panel (40), and a sealing structure (50), wherein the first protective panel (30) and the second protective panel (40) abut against two sides of the solar panel frame (10), respectively; the positive electrode lead (21) and the negative electrode lead (22) pass between the first protective panel (30) and the second protective panel (40) and then extend outward; the sealing structure (50) surrounds the solar panel frame (10) and is engaged between a periphery of the first protective panel (30) and a periphery of the second protective panel (40); the sealing structure (50) encloses a part of the positive electrode lead (21) and a part of the negative electrode lead (22) that extend out of the first protective panel (30) and the second protective panel (40); a sealed cavity (51) is formed between the first protective panel (30), the second protective panel (40), and the sealing structure (50).

2. The perovskite solar energy generation module (100,100A,100B,100C) as claimed in claim 1, wherein the at least one opening (11) comprises a plurality of openings (11); the at least one solar panel (20,20A,20B,20C) comprises a plurality of solar panels (20,20A,20B,20C); each of the plurality of solar panels (20,20A,20B,20C) is disposed on each of the plurality of openings (11); the solar panel frame (10) is an extruded aluminum frame; a first threaded portion (13) is formed in the solar panel frame (10); the first threaded portion (13) communicates with the two first holes (12); a plurality of solar panel slots (14) is formed on a periphery of the solar panel frame (10) corresponding to the plurality of openings (11); the plurality of solar panel slots (14) communicate with the first threaded portion (13); the plurality of solar panels (20,20A,20B,20C) are connected in series by leads passing through the first threaded portion (13).

3. The perovskite solar energy generation module (100,100A,100B,100C) as claimed in claim 2, wherein a periphery of each of the plurality of solar panels (20,20A,20B,20C) is fixed in each of the plurality of solar panel slots (14) by using an insulator (60).

4. The perovskite solar energy generation module (100,100A,100B,100C) as claimed in claim 3, wherein the insulator (60) working with each of the plurality of solar panels (20,20A,20B,20C) includes a plurality of gaskets (61); the plurality of gaskets (61) are disposed between a part of the periphery of each of the plurality of solar panels (20,20A,20B,20C) and an inner wall of each of the plurality of solar panel slots (14).

5. The perovskite solar energy generation module (100,100A,100B,100C) as claimed in claim 1, wherein the at least one solar panel (20,20A,20B,20C) has a perovskite solar cell (201), a top encapsulation (202), and a bottom encapsulation (203); the perovskite solar cell (201) is laminated between the top encapsulation (202) and the bottom encapsulation (203).

6. The perovskite solar energy generation module (100,100A,100B,100C) as claimed in claim 1, wherein both the first protective panel (30) and the second protective panel (40) are glasses.

7. A construction-shading device (200,200A,200B,200C), comprising:
an outer frame (70,70A,70B,70C) comprising two lateral frames (73), a top frame (71) connected between two top ends of the two lateral frames (73), and a bottom frame (72) connected between two bottom ends of the two lateral frames (73), wherein a solar module slot (76,76A,76B,76C) is formed on an inside of the outer frame (70,70A,70B,70C); a second threaded portion (74) is provided in the outer frame (70,70A,70B,70C); two second holes (75) communicate between the solar module slot (76,76A,76B,76C) and the second threaded portion (74); and
the perovskite solar energy generation module (100,100A,100B,100C) as claimed in claim 1, wherein a periphery of the perovskite solar energy generation module (100,100A,100B,100C) is fixed in the solar module slot (76,76A,76B,76C) by using a filling material (80); the positive electrode lead (21) and the negative electrode lead (22) of the perovskite solar energy generation module (100,100A,100B,100C) pass through the two second holes (75) to enter the second threaded portion (74).

8. The construction-shading device (200,200A,200B,200C) as claimed in claim 7, wherein a junction box (77) is disposed in the outer frame (70,70A,70B,70C); the positive electrode lead (21) and the negative electrode lead (22) of the perovskite solar energy generation module (100,100A,100B,100C) pass through the second threaded portion (74) to connect to the junction box (77).

9. The construction-shading device (200,200A,200B,200C) as claimed in claim 8, wherein the junction box (77) has a plurality of jacks (771); the plurality of jacks (771) are exposed on a surface of the outer frame (70,70A,70B,70C).

10. The construction-shading device (200,200A,200B,200C) as claimed in claim 7, wherein a handle (210A, 210B) is disposed on the outer frame (70,70A,70B,70C).
